# EUROPÄISCHE PATENTSCHRIFT

(11) **EP 2 804 228 B1**
(45) Veröffentlichungstag und Bekanntmachung des Hinweises auf die Patenterteilung: **27.12.2017**
(21) Anmeldenummer: 14168119.7
(22) Anmeldetag: 13.05.2014
(51) Int. Cl.: H01L 35/32

(54) **Thermoelektrisches Modul**
Thermoelectric module
Module thermoélectrique

(30) Priorität: 13.05.2013 DE 102013208764
(43) Veröffentlichungstag der Anmeldung: 19.11.2014
(73) Patentinhaber: MAHLE Behr GmbH & Co. KG, 70469 Stuttgart (DE)
(72) Erfinder: Angermann, Dr. rer. nat. Hans-Heinrich, 70567 Stuttgart (DE)
(74) Vertreter: Grauel, Andreas

(56) Entgegenhaltungen:
- DE-A1-102009 013 692
- DE-A1-102011 079 467
- DE-A1-102012 208 295
- US-A- 5 841 064
- US-A- 6 025 554
- US-B1- 6 410 971

## Beschreibung

### Technisches Gebiet

Die Erfindung betrifft ein thermoelektrisches Modul mit einem ersten Gehäuseelement und mit einem zweiten Gehäuseelement, wobei zwischen den Gehäuseelementen zumindest zwei thermoelektrische Elemente angeordnet sind, wobei zumindest jeweils zwei thermoelektrische Elemente über erste elektrische Kontaktierungen oder über zweite elektrische Kontaktierungen miteinander elektrisch verbunden sind oder über erste elektrische Kontaktierungen und/oder zweite elektrische Kontaktierungen mit einem Stromkreis elektrisch verbunden sind, wobei die ersten elektrischen Kontaktierungen dem ersten Gehäuseelement zugeordnet sind und die zweiten elektrischen Kontaktierungen dem zweiten Gehäuseelement zugeordnet sind.

### Stand der Technik

Thermoelektrische Module können sowohl als sogenannte Peltier-Elemente eingesetzt werden als auch als thermoelektrische Generatoren. Dabei kann entweder aufgrund einer anliegenden Spannung ein Wärmetransport realisiert werden, oder aufgrund einer Temperaturdifferenz entlang eines thermoelektrischen Moduls Strom erzeugt werden.

Der Aufbau der thermoelektrischen Module ist dabei in beiden Anwendungsfällen im Prinzip gleich. Thermoelektrische Module können beispielsweise aus mehreren aufeinander gestapelten Schichten und Bauelementen erzeugt werden. Oft sind thermoelektrische Elemente mittels elektrischer Kontaktierungen miteinander verschaltet. Die thermoelektrischen Elemente sind dabei in einem Gehäuse integriert. Zwischen dem Gehäuse und den elektrischen Kontaktierungen, beziehungsweise zwischen dem thermoelektrischen Elementen und dem Gehäuse kann eine elektrische Isolierung vorgesehen sein. Eine elektrische Isolierung ist insbesondere dann vorgesehen, wenn das Gehäuse aus einem elektrisch leitenden Material gebildet ist.

Um eine möglichst große Stromausbeute zu erzielen, ist eine möglichst große Temperaturdifferenz über das thermoelektrische Modul vorteilhaft. Obwohl das thermoelektrische Modul Wärme von einer Außenfläche zu einer anderen Außenfläche transportiert, ergibt sich aus der gewollten geringen Wärmeleitfähigkeit der thermoelektrisch aktiven Materialien eine Temperaturdifferenz zwischen den jeweiligen Außenflächen. Je weniger Wärme transportiert wird, desto größer ist die auftretende Temperaturdifferenz.

Nachteilig bei thermoelektrischen Modulen ist insbesondere, dass es aufgrund der großen Temperaturdifferenzen zu unterschiedlichen Ausdehnungen des thermoelektrischen Moduls auf der jeweils heißen und der jeweils kalten Seite kommt. Dies resultiert in hohen mechanischen Beanspruchungen der thermoelektrischen Module und kann zum Versagen der thermoelektrischen Module führen.

Nachteilig an den Lösungen im Stand der Technik ist insbesondere die nicht optimale Werkstoffauswahl für die jeweilige heiße Seite und die jeweilige kalte Seite der thermoelektrischen Module.

Die US 5 841 064 offenbart ein thermoelektrisches Modul gemäß dem Oberbegriff von Anspruch 1.

### Darstellung der Erfindung, Aufgabe, Lösung, Vorteile

Es ist die Aufgabe der vorliegenden Erfindung ein thermoelektrisches Modul bereitzustellen, welches gegenüber dem Stand der Technik optimiert ist und sich insbesondere durch anwendungsgerechte Materialien auszeichnet.

Die Aufgabe der vorliegenden Erfindung wird durch ein thermoelektrisches Modul mit den Merkmalen gemäß Anspruch 1 gelöst.

Ein Ausführungsbeispiel der Erfindung betrifft ein thermoelektrisches Modul mit einem ersten Gehäuseelement und mit einem zweiten Gehäuseelement, wobei zwischen den Gehäuseelementen zumindest zwei thermoelektrische Elemente angeordnet sind, wobei zumindest jeweils zwei thermoelektrische Elemente über erste elektrische Kontaktierungen oder über zweite elektrische Kontaktierungen miteinander elektrisch verbunden sind oder die zumindest jeweils zwei thermoelektrischen Elemente über erste elektrische Kontaktierungen und/oder zweite elektrische Kontaktierungen mit einem Stromkreis elektrisch verbunden sind, wobei die ersten elektrischen Kontaktierungen dem ersten Gehäuseelement zugeordnet sind und die zweiten elektrischen Kontaktierungen dem zweiten Gehäuseelement zugeordnet sind, wobei das erste Gehäuseelement und/oder das zweite Gehäuseelement eine Dicke von weniger als 0,3 mm aufweist.

Dünne Gehäuseelemente werden bereits bei deutlich niedrigeren thermomechanischen Spannungen verformt, bevorzugt können sie elastisch verformt werden, als dies bei dickeren Gehäuseelementen der Fall ist. Diese Kräfte liegen dann nicht mehr im Modulinneren an den diversen Materialien und Fügeverbindungen an.

Insbesondere durch eine möglichst dünne Gestaltung des Gehäuseelementes der kalten Seite können durch elastische oder ggf. auch plastische Verformungen thermomechanische Kräfte abgebaut werden. Vorteilhafterweise kann das Gehäuseelement der kalten Seite dabei aus einem folienartigen Material gebildet sein. Dies ist insbesondere bei der Verwendung von metallischen Werkstoffen vorteilhaft.

Vorzugsweise weist das erste Gehäuseelement und/oder das zweite Gehäuseelement eine Dicke von weniger als 0,2 mm, bevorzugt von weniger als 0,1 mm auf. Je dünner das Gehäuseelement ist, desto leichter können thermomechanische Kräfte durch Verformung kompensiert werden.

Vorzugsweise ist das erste Gehäuseelement (Kaltseite) aus zumindest einem der Materialien Aluminium, Magnesium, Zink, Kupfer und Mangan gebildet oder aus einer Legierung von zumindest einem der Materialien Aluminium, Magnesium, Zink, Kupfer, Mangan und Eisen gebildet, wobei das zweite Gehäuseelement (Heißseite) aus einem Material mit einem Wärmeausdehnungskoeffizienten a gebildet ist, der kleiner als 20 x 10⁻⁶ 1/K ist, dabei vorzugsweise kleiner als 16 x 10⁻⁶ 1/K ist, dabei vorzugsweise kleiner als 12 x 10⁻⁶ 1/K ist.

Thermoelektrische Module werden für ihren Einsatz oft einer Umgebung ausgesetzt, die sich insbesondere durch große Temperaturdifferenzen auszeichnet. Die Temperaturdifferenz kann beispielsweise durch zwei Medien unterschiedlicher Temperatur erzeugt werden, welche das thermoelektrische Modul umströmen. Dabei werden besonders die Gehäuseelemente den Temperaturdifferenzen ausgesetzt. Im Wesentlichen findet der Wärmeübertrag zwischen dem thermoelektrischen Modul und den Medien über die Gehäuseelemente statt.

Das Gehäuseelement, welches dem Medium mit der höheren Temperatur ausgesetzt ist, bildet eine heiße Seite des thermoelektrischen Moduls aus. Das jeweils andere Gehäuseelement bildet eine kalte Seite des thermoelektrischen Moduls aus. Dies trifft zumindest für thermoelektrische Module zu, die zur Stromerzeugung verwendet werden.

Thermoelektrische Module, die dazu genutzt werden, Wärme zu transportieren, können auch zwei Medien gleicher Temperatur ausgesetzt sein. Durch Leitung von elektrischem Strom über das thermoelektrische Modul bilden sich am thermoelektrischen Modul auch jeweils eine heiße Seite und eine kalte Seite aus.

Für das Gehäuseelement der kalten Seite kommen bevorzugt Materialien zum Einsatz, welche sich durch einen hohen Wärmeausdehnungskoeffizienten a auszeichnen. Weiterhin ist flankierend ein möglichst geringer Elastizitätsmodul E vorteilhaft. Der spezifische elektrische Widerstand spielt für die Materialauswahl der Gehäuseelemente keine Rolle. Das thermoelektrische Modul erfährt im Betrieb aufgrund der Temperaturen der umgebenden Medien mechanische Spannungen, welche in einer Dehnung oder Stauchung des thermoelektrischen Moduls resultieren. Um den elastischen Anteil an der auftretenden Verformung infolge der Erwärmung beziehungsweise der Abkühlung möglichst groß zu halten, ist ein möglichst geringer Elastizitätsmodul E vorteilhaft.

Als Materialien für das Gehäuseelement der kalten Seite kommen daher bevorzugt Aluminium, Aluminiumlegierungen, Magnesium, Magnesiumlegierungen, Zink oder Zinklegierungen, Mangan und Manganlegierungen sowie austenitische Eisenlegierungen in Frage. Kupfer oder Kupferlegierungen sind ebenfalls vorsehbar. Sie weisen einen etwas niedrigeren Wärmeausdehnungskoeffizienten a auf. Unter den Fe-Legierungen sind besonders die üblichen kostengünstigen austenitischen Edelstähle wie z.B. 1.4301 zu nennen, die jedoch auch bei Raumtemperatur einen eher niedrigen Wärmeausdehnungskoeffizienten von ca. 16·10⁻⁶ 1/K aufweisen. Auch Werkstoffe mit besonders hohem thermischem Ausdehnungskoeffizienten wie beispielsweise Pernifer 1407, Pernifer 2002, Pernifer 2006, Pernifer 2203, Pernifer 2508 und Materialien wie Pernima 72 VDM können eingesetzt werden. Pernima 72 zeichnet sich besonders durch einen sehr hohen Wärmeausdehnungskoeffizienten a aus. Insbesondere vorteilhaft ist hier das Material Aluminium oder dessen Legierungen. Aluminium weist sowohl einen hohen Wärmeausdehnungskoeffizienten a als auch einen niedrigen Elastizitätsmodul E auf. Darüber hinaus sind Aluminium und dessen Legierungen kostengünstig, global verfügbar, leicht verarbeitbar und relativ korrosionsbeständig. Diese Vorteile gelten ebenso für die elektrischen Kontaktierungen, insbesondere die Leiterbahnen, der kalten Seite.

Darüber hinaus lässt sich auf Aluminiumwerkstoffe für das erste Gehäuseelement leicht eine elektrisch isolierende Schicht aufbringen. Dies kann beispielsweise durch Eloxieren erfolgen.

Nachfolgend ist eine Tabelle mit unterschiedlichen Materialien dargestellt, welche vorteilhafterweise für das Gehäuseelement der kalten Seite verwendet werden können. Es sind der Wärmeausdehnungskoeffizient a und der Elastizitätsmodul E bei Raumtemperatur dargestellt. Mit Blick auf eine Verwendung der vorgeschlagenen Materialien als elektrische Kontaktierung wird der spezifische elektrische Widerstand mit aufgeführt.

**Tabelle 1: Materialparameter ausgewählter Materialien, insbesondere für das Gehäuseelement der kalten Seite, bei Raumtemperatur**

| | α in 10⁻⁶/K | σ in Ωmm²/m | E in GPa |
|---|---|---|---|
| Aluminium (Al) | 23,8 | 2,7E-02 | 68 |
| Magnesium (Mg) | 24,5 | 4,5E-02 | 45 |
| Zink (Zn) | 29,8 | 5,9E-02 | 94 |
| Kupfer (Cu) | 16,5 | 1,7E-02 | 125 |
| Mangan (Mn) | 21,7 | 1,6 | 191 |
| Austenitischer Edelstahl, z.B. 1.4301 | 16,0 | 0,73 | 200 |

Als Materialien für das Gehäuseelement der heißen Seite kommen bevorzugt Materialien zum Einsatz, die einen Wärmeausdehnungskoeffizienten a von kleiner als 20 x 10⁻⁶ 1/K ist, vorzugsweise kleiner als 16 x 10⁻⁶ 1/K ist, dabei vorzugsweise kleiner als 12 x 10⁻⁶ 1/K ist.

Je niedriger der Wärmeausdehnungskoeffizient α ist, umso vorteilhafter ist das Material für das Gehäuseelement der heißen Seite. Der niedrige Wärmeausdehnungskoeffizient a führt zu einer geringeren Ausdehnung des Gehäuseelementes infolge hoher Temperaturen. Dies ist insbesondere der Dauerhaltbarkeit des thermoelektrischen Moduls zuträglich, da die Belastungen durch eine geringere Ausdehnung oder Stauchung ebenfalls verringert werden.

Weiterhin kann es besonders vorteilhaft sein, wenn das zweite Gehäuseelement aus zumindest einem der Materialien Molybdän, Wolfram, Tantal, Niob, Chrom, Nickel, Aluminiumoxid, Aluminiumnitrid, Zirkonoxid, Siliziumcarbid, Siliziumnitrid gebildet ist oder aus einer Legierung aus zumindest einem der Materialien Molybdän, Wolfram, Tantal, Niob, Chrom, Nickel und Eisen gebildet ist. Des weiteren können z.B. bestimmte austenitische Fe-Basis-Legierungen mit besonders niedrigem Wärmeausdehnungsgkoeffizienten wie Pernifer-Legierungen, z.B. Pernifer 2918, den ferritischen Edelstählen 1.4016, 1.4509 etc. und/oder dem ferritischen Edelstahl 1.4737 verwendet werden.

Für das zweite Gehäuseelement, also das Gehäuseelement der heißen Seite, kommen besonders Eisenwerkstoffe und Legierungen auf Eisenbasis in Frage. Hierzu zählen beispielsweise die Stähle 1.4016, 1.4509, 1.4737 sowie die vorbeschriebenen einschlägigen Fe-Basis Pernifer-Legierungen mit besonders niedrigem thermischen Ausdehnungskoeffizienten. Weiterhin sind Refraktärmetalle wie Molybdän, Wolfram, Tantal, Niob, Chrom sowie deren jeweilige Legierungen für das Gehäuseelement der heißen Seite verwendbar. In Frage kommen auch Ni und Nickelbasislegierungen, die zwar einen etwas erhöhten thermischen Ausdehnungskoeffizienten aufweisen, jedoch auch bei erhöhten Temperaturen noch eine Streckgrenze von ca. 400 MPa aufweisen.

Als Alternative zu metallischen Gehäuseelementen können auch keramische Materialien verwendet werden. Hierzu zählen beispielsweise Aluminiumoxid (Al₂O₃), Aluminiumnitrid (AIN), Zirkonoxid (ZrO₂), Siliziumcarbid (SiC), Siliziumnitrid (Si₃N₄) sowie Mischoxide. Dies gilt mit Blick auf den Wärmeausdehnungskoeffizienten a insbesondere für das Gehäuseelement der heißen Seite.

In der nachfolgenden Tabelle sind die Parameter Wärmeausdehnungskoeffizient a, spezifischer elektrische Widerstand σ sowie der Elastizitätsmodul E für verschiedene besonders geeignete Stähle, Refraktärmetalle und eine Keramik dargestellt.

**Tabelle 2: Materialparameter ausgewählter Materialien, insbesondere für das Gehäuseelement der heißen Seite, bei Raumtemperatur**

| | α in 10⁻⁶/K | σ in Ωmm²/m | E in GPa |
|---|---|---|---|
| 1.4016/1.4509 | 10,0 | 6,0E-01 | 220 |
| 1.4737 | 10,5 | 6,0E-01 | 220 |
| Pernifer 2918 | 6,5 | 4,9E -01 | 160 |
| Molybdän (Mo) | 5,0 | 5,1E-02 | 336 |
| Wolfram (W) | 4,5 | 5,5E-02 | 415 |
| Tantal (Ta) | 6,6 | 1,2E-01 | 188 |
| Niob (Nb) | 8,6 | 1,3E-01 | 160 |
| Chrom (Cr) | 7,2 | 1,4E-01 | 190 |
| Al₂O₃ (99,7%) | 8,5 | --- | 380 |
| Nickel (Ni) | 13,4 | 1,4 | 200 |

Besonders bevorzugt sind für das Gehäuseelement der heißen Seite Materialien auf Eisenbasis. Diese sind global gut verfügbar, weisen eine gute Verarbeitbarkeit auf und sind kostengünstig am Markt zu beziehen. Auch Ni-Basis-Legierungen gehören dazu wegen der hohen Warmstreckgrenze, die auch bei erhöhten mechanischen Spannungen noch eine elastische Verformung erlaubt.

Der Wärmeausdehnungskoeffizient a des ersten Gehäuseelementes und/oder der ersten elektrischen Kontaktierungen (Kaltseite) ist größer als der Wärmeausdehnungskoeffizient a des zweiten Gehäuseelementes und/oder der zweiten elektrischen Kontaktierungen (Heißseite).

Auf der heißen Seite können typischerweise Temperaturen von ungefähr 400° bis 550° Celsius auftreten. Auf der kalten Seite hingegen können Temperaturen bis ungefähr 120° Celsius auftreten. Die Verwendung von gleichen Materialien führt daher zu einer stark unterschiedlichen Entstehung von mechanischen Spannungen an dem Gehäuseelement der kalten Seite und dem Gehäuseelement der heißen Seite. Dies kann zu Beeinträchtigungen der Dauerhaltbarkeit des thermoelektrischen Moduls oder zum Ausfall des thermoelektrischen Moduls führen.

Daher ist es besonders vorteilhaft, wenn die Gehäuseelemente und die elektrischen Kontaktierungen auf der heißen Seite, welche sich durch eine flächige Ausdehnung auszeichnen, aus einem Material gebildet sind, welches sich durch einen möglichst geringen Wärmeausdehnungskoeffizienten a auszeichnet. Die Gehäuseelemente und die elektrischen Kontaktierungen auf der kalten Seite sind vorteilhafterweise aus einem Material mit einem hohen Wärmeausdehnungskoeffizienten a gebildet.

Der hohe Wärmeausdehnungskoeffizient α an der kalten Seite ist insbesondere vorteilhaft, da auch an der kalten Seite eine gewisse Erwärmung gegenüber Raumtemperatur im Betrieb auftritt. Durch ein Material mit einem hohen Wärmeausdehnungskoeffizienten a auf der kalten Seite können die Ausdehnungsunterschiede zwischen der heißen Seite und der kalten Seite abgemildert werden.

Nach einer vorteilhaften Ausführungsform besteht das Gehäuseelement auf der im Betrieb zu kühlenden Seite aus einem Metall. Das Gehäuseelement ist somit elastisch oder plastisch verformbar.

Darüber hinaus kann es vorteilhaft sein, wenn jeweils zwischen den ersten elektrischen Kontaktierungen und dem ersten Gehäuseelement und/oder zwischen den zweiten elektrischen Kontaktierungen und dem zweiten Gehäuseelement eine elektrische Isolierung angeordnet ist.

Um Kurzschlüsse zu vermeiden, können zwischen den elektrischen Kontaktierungen und den jeweiligen Gehäuseelementen elektrische Isolierungen vorgesehen sein.

Dies gilt besonders dann, wenn für die Gehäuseelemente elektrisch leitende Materialien verwendet werden.

Die elektrische Isolierung kann vollflächig auf den Gehäuseelementen oder den elektrischen Kontaktierungen aufgebracht sein. Vorteilhaft ist es, wenn die elektrische Isolierung zwischen den elektrischen Kontaktierungen und den Gehäuseelementen nicht vollflächig aufgebracht ist, da dadurch die thermomechanischen Kräfte durch Verformung eines geeignet dünnen Gehäuseelements besser abgebaut werden können.

Vorteilhaft weist die elektrische Isolierung die geometrische Form der elektrischen Kontaktierungen auf, steht jedoch zwischen 0,1 und 1,0 mm, bevorzugt zwischen 0,25 und 0,75 mm, über diese hinaus.

Es ist nützlich, wenn die elektrische Isolierung nur soweit über die elektrischen Kontaktierungen hinaussteht, dass ein elektrischer Kontakt zwischen den Gehäuseelementen und den elektrischen Kontaktierungen vermieden wird. Dies ist insbesondere zu erreichen, indem die elektrische Isolierung um beispielsweise 0,1 mm bis 1,0 mm, bevorzugt 0,25 bis 0,75 mm über die elektrischen Kontaktierungen hinaussteht. Falls gewünscht kann der Überstand der elektrischen Isolierungen nach dem Aufbringen der elektrischen Leiterbahnen auch ganz oder zumindest teilweise wieder entfernt werden.

Auch ist es zu bevorzugen, wenn die elektrische Isolierung und/oder die elektrischen Kontaktierungen durch thermisches Spritzen auf die Gehäuseelemente und/oder die thermoelektrischen Elemente aufgebracht sind.

Durch thermisches Aufspritzen der elektrischen Isolierung und/oder der elektrischen Kontaktierungen auf die Gehäuseelemente und/oder die thermoelektrischen Elemente kann auf besonders einfache Weise eine stoffschlüssige Verbindung zwischen dem jeweils aufgespritztem Material und dem jeweiligen Trägermaterial erzeugt werden. Der Prozess des thermischen Aufspritzens ist dabei einfach in einem industriellen Prozess automatisierbar, so dass die Bearbeitung kostengünstig erfolgen kann.

Besonders vorteilhaft können keramische Schichten wie z.B. Al₂O₃ zur elektrischen Isolierung aufgebracht werden. Falls nötig, kann die Haftung der gespritzten Schichten durch das Aufbringen von Haftzwischenschichten/Pufferschichten wie z.B. NiCrA-IY verbessert werden. Dies bietet sich insbesondere für das Gehäuseelement der kalten Seite an. NiCrAlY stellt mit einem Wärmeausdehnungskoeffizienten von ca. 14 eine Übergangsschicht zwischen dem hohen Wert für das Gehäuseelement der kalten Seite und der isolierenden Keramik dar. Es wirkt sich in diesem Zusammenhang der eher poröse Charakter der isolierenden Keramikschicht vorteilhaft aus, die mithilft, mechanische Spannungen durch gewisse Bewegung innerhalb der Schicht abbauen zu können.

In einer besonders günstigen Ausgestaltung der Erfindung ist es außerdem vorgesehen, dass für das erste Gehäuseelement und/oder die ersten elektrischen Kontaktierungen ein Material verwendbar ist, dessen Elastizitätsmodul E in einem Bereich von 5 GPa bis 200 GPa, bevorzugt von 15 GPa bis 120 GPa, dabei bevorzugt von 20 GPa bis 100 GPa liegt. Hier bieten sich vor dem Hintergrund von Kosten und Verfügbarkeit besonders Al und Al-Legierungen an.

Ein möglichst geringer Elastizitätsmodul E ist besonders vorteilhaft, um einen möglichst hohen elastischen Verformungsanteil an der Gesamtverformung zu erreichen. Insbesondere für das Gehäuseelement und/oder die elektrischen Kontaktierungen auf der kalten Seite sind dabei vorzugsweise Materialien mit einem Elastizitätsmodul E in einem oben genannten Bereich vorteilhaft. Ein möglichst hoher elastischer Verformungsanteil ist der Lebensdauer des thermoelektrischen Moduls zuträglich, da der plastische Verformungsanteil entsprechend geringer ausfällt.

Auch ist es vorteilhaft, wenn für das zweite Gehäuseelement und/oder die zweiten elektrischen Kontaktierungen ein Material verwendbar ist, dessen Elastizitätsmodul E in einem Bereich von 100 GPa bis 500 GPa, bevorzugt von 140 GPa bis 300 GPa, dabei bevorzugt von 160 GPa bis 250 GPa liegt.

Für das Gehäuseelement und/oder die elektrischen Kontaktierungen der heißen Seite wird vorteilhafterweise ein Material verwendet, welches einen Elastizitätsmodul E im oben stehenden Bereich aufweist. Dies ist dem Umstand geschuldet, dass primäres Auswahlkriterium für Materialien der Heißseite ein niedriger thermischer Ausdehnungskoeffizient ist und solche Werkstoffe einen Wert des E-Moduls in eher höherem Bereich aufweisen. Grundsätzlich gilt hier auch, dass ein möglichst niedriger Elastizitätsmodul E zu bevorzugen ist. Im Vergleich zu den Materialien, welche für das Gehäuseelement und/oder die elektrischen Kontaktierungen der kalten Seite verwendet werden, liegt der vorteilhafte Bereich des Elastizitätsmoduls E für das Gehäuseelement und/oder die elektrischen Kontaktierungen der heißen Seite höher. Dies ist jedoch insbesondere den anderen die Materialwahl beeinflussenden Parametern geschuldet. Auch auf der heißen Seite ist ein möglichst niedriger Wert für den Elastizitätsmodul E zu wählen.

In einer alternativen vorteilhaften Ausgestaltung der Erfindung kann es vorgesehen sein, dass die ersten elektrischen Kontaktierungen und/oder die zweiten elektrischen Kontaktierungen aus einem mehrlagigen Material gebildet sind.

Die elektrischen Kontaktierungen können beispielsweise durch Leiterbahnen gebildet sein. Insbesondere für die elektrischen Kontaktierungen der kalten Seite kann vorteilhaft Aluminium oder eine Aluminiumlegierung verwendet werden. Dies ist durch die für den Einsatzzweck guten Materialparameter begründet. Aluminium oder Aluminiumlegierungen weisen einen hohen Wärmeausdehnungskoeffizienten α auf, ein niedrigen Elastizitätsmodul E und einen niedrigen spezifischen elektrischen Widerstand o. Ein möglichst niedriger elektrischer Widerstand der Leiterbahnen ist wünschenswert, daher wird im Allgemeinen der Reinstoff, in diesem Fall Aluminium, der Legierung, in diesem Fall der Al-Legierung, vorgezogen. Wie zwischen Gehäuseelement und elektrischer Isolierschicht kann auch zwischen elektrischer Isolierschicht und Leiterbahn eine Haftzwischenschicht aufgebracht sein.

Um einen besseren Haftgrund, etwa für die Verbindung mit den thermoelektrischen Elementen oder den Gehäuseelementen, zu schaffen, kann beispielsweise eine weitere Materiallage auf das Basismaterial der elektrischen Kontaktierungen aufgebracht werden. Dabei kann beispielsweise eine Silberschicht durch Verfahren wie das thermische Spritzen oder das Tampongalvanisieren auf die elektrischen Kontaktierungen aufgebracht werden.

Darüber hinaus kann es vorteilhaft sein, wenn die ersten elektrischen Kontaktierungen und/oder die zweiten elektrischen Kontaktierungen durch Leiterbahnen gebildet sind, wobei diese bevorzugt mehr als 1 mm, dabei bevorzugt mehr als 2 mm, dabei bevorzugt mehr als 3 mm zueinander beabstandet sind.

Um eine möglichst gute Verformungsfähigkeit der Gehäuseelemente zu erhalten, ist es vorteilhaft, wenn die elektrischen Kontaktierungen, welche insbesondere durch Leiterbahnen gebildet sein können, in einem oben angegebenen Abstand zueinander angeordnet sind. Dies gilt auch für die elektrischen Isolierungen. Es ist vorteilhaft, diese nicht vollflächig auf die Gehäuseelemente aufzubringen, sondern mit Abstand voneinander, so dass das Gehäuseelement sich unter im Betrieb auftretenden Spannungen verformen kann. Der vorher angegebene Abstand zwischen den Leiterplatten verringert sich für die elektrischen Isolierschichten um den doppelten Überstand der elektrischen Isolierschichten über die Leiterbahnen.

Auch kann es zweckmäßig sein, wenn das Fügen des jeweiligen Gehäuseelementes und der jeweiligen elektrischen Kontaktierungen und der thermoelektrischen Elemente bei einer Temperatur erfolgt, welche in einem Intervall von ± 50° Celsius um eine Mitteltemperatur zwischen der Umgebungstemperatur und der jeweiligen Anwendungstemperatur des thermoelektrischen Moduls liegt.

Dies ist insbesondere vorteilhaft, da bei der jeweiligen Fügetemperatur die thermomechanischen Spannungen im Material gleich Null sind. Aus thermomechanischer Sicht ist es für das thermoelektrische Modul besonders vorteilhaft, wenn die thermomechanische Spannung, welche das Modul zwischen dem Betriebszustand und dem Ruhezustand erfährt, um einen Nullwert pendelt.

Ein mögliches Fügeverfahren zur Fügung des Gehäuseelementes und der jeweiligen elektronischen Kontaktierungen ist beispielsweise das Silbersintern. Silbersintern kann insbesondere auch eingesetzt werden, um die elektrischen Kontaktierungen mit den thermoelektrischen Elementen zu verbinden.

Weiterhin kann es besonders vorteilhaft sein, wenn die ersten elektrischen Kontaktierungen und/oder die zweiten elektrischen Kontaktierungen aus einem Material gebildet sind, das einen möglichst niedrigen spezifischen elektrischen Widerstand σ von kleiner 0,6 Ωmm²/m aufweist, dabei vorzugsweise kleiner als 0,1 Ωmm²/m, dabei vorzugsweise kleiner als 0,06 Ωmm²/m.

Generell ist es sowohl für die elektrischen Kontaktierungen auf der kalten Seite als auch für die elektrischen Kontaktierungen auf der heißen Seite vorteilhaft, wenn der spezifische elektrische Widerstand σ möglichst gering ist, damit bei einer gegebenen Leiterbahndicke die ohmsche Verlustleistung möglichst gering ist. Umgekehrt bleibt die Leiterbahndicke bei einer vorgegebenen maximalen ohmschen Verlustleistung ebenfalls möglichst gering.

Insbesondere für das Material der elektrischen Kontaktierungen auf der heißen Seite kommen vorteilhafterweise Materialien mit einem niedrigen Wärmeausdehnungskoeffizienten α und einem niedrigen spezifischen elektrischen Widerstands σ zum Einsatz. Daher sind besonders Molybdän, Wolfram sowie deren Legierungen vorteilhaft. Ein Beispiel für eine vorteilhafte Legierung ist Molybdän-Rhenium 5 (MoRe5), welche zusätzlich eine vorteilhafte Duktilität aufweist.

Wolfram und Wolframlegierungen haben gegenüber Molybdän und Molybdänlegierungen den Vorteil, dass sie einen noch niedrigeren Wärmeausdehnungskoeffizienten α aufweisen und bei höheren Temperaturen eine höhere Beständigkeit gegen Oxidation aufweisen.

Vorteilhaft vor dem Hintergrund von Kosten und einer geringen Differenz der thermischen Ausdehnung zwischen zweitem Gehäuseelement (vorteilhaft aus einem ferritschen Edelstahl wie 1.4016 oder 1.4509) und zweiter elektrischer Kontaktierung wird die zweite elektrische Kontaktierung aus Fe, Ni oder Ti gefertigt.

Ferner ist vorteilhaft, wenn zwischen den einzelnen Schichten und Bausteinen Pufferschichten, insbesondere aus NiCrAlY, einer Al-Cu-Legierungen oder einer Al-Si-Legierung, aufgebracht sind. Die Pufferschichten werden zwischen Materialien mit unterschiedlichen thermischen Ausdehnungskoeffizienten eingebracht. Idealerweise liegt der Wert des thermischen Ausdehnungskoeffizienten der Pufferschicht in der Mitte der Koeffizienten dieser Materialien.

Ausführungsformen der vorliegenden Erfindung sind in der nachfolgenden Figurenbeschreibung detailliert erläutert.

### Kurze Beschreibung der Zeichnungen

Im Folgenden wird die Erfindung anhand von Ausführungsbeispielen unter Bezugnahme auf die Zeichnungen detailliert erläutert. In den Zeichnungen zeigen:

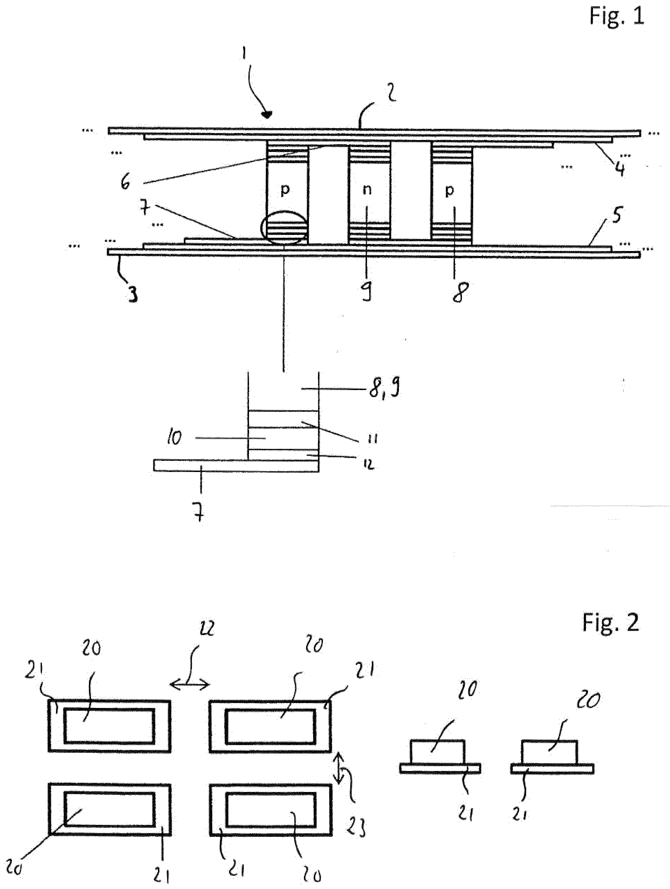

- Fig.1: im oberen Teil eine Schnittansicht durch ein thermoelektrisches Modul mit einer Mehrzahl zueinander benachbart angeordneter thermoelektrischer Elemente, wobei die thermoelektrischen Elemente über elektrische Kontaktierungen miteinander verbunden sind und über elektrische Isolierungen von den Gehäuseelementen isoliert sind und im unteren Teil der Fig. 1 eine Detailansicht des Fußbereichs eines der thermoelektrischen Elemente, und
- Fig. 2: im linken Teil der Fig. 2 eine Aufsicht auf vier zueinander benachbarte elektrische Kontaktierungen mit den jeweiligen elektrischen Isolierungen und im rechten Teil der Fig. 2 eine Seitenansicht von jeweils zwei elektrischen Kontaktierungen und zwei elektrischen Isolierungen.

### Bevorzugte Ausführung der Erfindung

Die Fig. 1 zeigt in der oberen Darstellung den grundsätzlichen Aufbau eines thermoelektrischen Moduls 1 gemäß einem Ausführungsbeispiel der vorliegenden Erfindung. Gezeigt ist eine Schnittansicht durch das thermoelektrische Modul 1.

Das thermoelektrische Modul 1 weist ein erstes Gehäuseelement 2 und ein zweites Gehäuseelement 3 auf. Die Gehäuseelemente 2, 3 sind in Fig. 1 als im Wesentlichen flächige ebene Körper dargestellt. Fig. 1 zeigt nur einen Teilbereich des thermoelektrischen Moduls 1. Im nicht gezeigten Bereich können die Gehäuseelemente 2, 3 derart fortgesetzt sein, dass sie miteinander in Kontakt treten und das thermoelektrische Modul nach außen hin abschließen. Ebenso kann es vorgesehen sein, dass die Gehäuseelemente nicht parallel zueinander verlaufen oder beispielsweise Oberflächenelemente wie Rippen aufweisen.

Die Gehäuseelemente 2, 3 sind jeweils aus einem Grundmaterial hergestellt. Als Grundmaterial kommen insbesondere sowohl metallische Materialien als auch keramische Materialien in Frage. Genauere Ausführungen zu den in Frage kommenden Materialien und die jeweils zu bevorzugenden Materialparameter sind in der vorausgegangenen Beschreibungseinleitung enthalten.

In der Fig. 1 ist auf jedem der Gehäuseelemente 2, 3 eine elektrische Isolierung 4, 5 im Wesentlichen vollflächig aufgebracht. Die elektrische Isolierung 4, 5 ist insbesondere dann erforderlich, wenn die Gehäuseelemente 2, 3 aus einem metallischen Material oder einem anderen elektrisch leitenden Material gefertigt sind. Als elektrische Isolierung 4, 5 können insbesondere keramische Schichten vorgesehen werden. Diese können beispielsweise thermisch aufgespritzt werden. Zwischen den Gehäuseelementen 2, 3 und den elektrischen Isolierungen 4, 5 können Haftvermittlungsschichten/Pufferschichten wie z.B. NiCrAlY, Al-Cu oder Al-Si-Legierungen aufgebracht werden (in Fig. 1 nicht dargestellt).

Die elektrischen Isolierungen 4, 5 trennen die Gehäuseelemente 2, 3 von den elektrischen Kontaktierungen 6, 7, welche die thermoelektrischen Elemente 8, 9 miteinander und mit einem nicht gezeigten Stromkreis verbinden.

Die elektrischen Kontaktierungen 6, 7 können dabei wie in Fig. 1 gezeigt durch Leiterbahnen gebildet sein, welche entweder auf die elektrische Isolierung 4, 5, die Gehäuseelemente 2, 3 oder die thermoelektrischen Elemente 8, 9 aufgebracht sind. Die Leiterbahnen können durch eine metallische Lage gebildet sein, welche beispielsweise durch thermisches Spritzen aufgebracht wird.

Bei den thermoelektrischen Elementen 8, 9 handelt es sich um p-dotierte Halbleiter und n-dotierte Halbleiter. Diese sind über die elektrischen Kontaktierungen 6, 7 beispielsweise abwechselnd in Reihe geschaltet. Es ist dabei abwechselnd ein p-dotierter Halbleiter mit einem benachbarten n-dotierten Halbleiter verschaltet. Die Anzahl der thermoelektrischen Elemente 8, 9 ist dabei variabel. Abweichend zur gezeigten Reihenschaltung können die thermoelektrischen Elemente auch in abweichenden Schaltungsanordnungen angeordnet sein.

Im unteren Bereich der Fig. 1 ist beispielhaft ein Fußbereich eines p-dotierten Halbleiters gezeigt, der mit einer elektrischen Kontaktierung 7 verbunden ist. Dabei sind verschiedene Zwischenschichten zwischen dem p-dotierten Halbleiter und der elektrischen Kontaktierung 7 angeordnet. Der gezeigte Fußbereich ist dem unteren Gehäuseelement 3 zugewandt. Für einen n-dotierten Halbleiter, die elektrischen Kontaktierungen 6 sowie die dazwischen angeordneten Zwischenschichten gelten die Ausführungen analog. Ebenso gelten die Ausführungen für den jeweiligen Kopfbereich der thermoelektrischen Elemente 8, 9, welche dem oberen Gehäuseelement 2 zugewandt sind, analog.

Es ist zu erkennen, dass der p-dotierte Halbleiter über ein Fügematerial 10 an die elektrische Kontaktierung 7 angebunden ist. Zwischen dem Fügematerial 10 und dem p-dotierten Halbleiter ist eine Schicht 11 angeordnet. Zwischen der elektrischen Kontaktierung 7 und dem Fügematerial 10 ist eine Schicht 12 angeordnet. Die Schichten 11 und 12 können einlagig oder bevorzugt mehrlagig sein, wobei jede Schicht aus einem anderen Material besteht und eine spezifische Aufgabe hat. Beispielhaft entspricht in Fig. 1 die Schicht 11 einer Diffusionsbarriere und einer Haftvermittlungsschicht und die Schicht 12 einer Haftvermittlungsschicht.

Allgemein werden als Schichten eine Pufferschicht, die die schädliche Auswirkung von unterschiedlichen Wärmeausdehnungskoeffizienten beseitigt oder mildert, wie z.B. NiCrAlY, Al-Cu- oder Al-Si-Legierungen, eine Diffusionsbarriere, die eine Eindiffusion von Atomen oder Molekülen aus dem Fügematerial 10 in das thermoelektrisch aktive Material des thermoelektrischen Elementes 8 verhindert oder mildert, und eine Haftvermittlungsschicht, die eine gute Haftung des Fügematerials erlaubt, verwendet. Eine Eindiffusion könnte eine Verschlechterung der thermoelektrischen Eigenschaften des thermoelektrischen Elementes 8 nach sich ziehen.

Zwischen dem Gehäuselement und der elektrischen Isolierschicht kann eine Pufferschicht angeordnet sein. Eine solche Pufferschicht kann auch zwischen der elektrischen Isolierung und der elektrischen Kontaktierung angeordnet sein.

Die Haftvermittlungsschicht kann im Fall, dass das Fügematerial ein Ag-Sintermaterial ist, beispielsweise aus Ag oder Au bestehen.

Das Fügematerial 10 kann beispielsweise unter Anwendung einer temperaturunterstützten Pressung aufgebracht werden. Alternativ kann das Fügematerial 10 über thermisches Aufspritzen aufgetragen werden oder in Form einer Paste aufdosiert, aufgedruckt etc. oder in Form einer Folie aufgelegt sein.

Die Haftvermittlungsschicht 12 kann beispielsweise über thermisches Aufspritzen auf die elektrische Kontaktierung 7 aufgebracht werden. Die Haftvermittlungsschicht 12 kann vorteilhafterweise durch Silber oder ein Material auf Silberbasis gebildet sein.

Alternativ oder zusätzlich kann auch die Schicht, welche in der Fig. 1 die Diffusionsbarriere 11 bildet, als Haftvermittlungsschicht ausgebildet sein oder eine entsprechende Teilschicht aufweisen, die eine derartige Haftunterstützungsfunktion erfüllt. Ferner ist es auch vorsehbar, dass die zweite Schicht, welche die Haftvermittlungsschicht 12 bildet, eine Barrierewirkung gegen eine Ausdiffusion von Atomen oder Molekülen aus dem Fügematerial 10 aufweist. Bei geeigneter Wahl der Materialien der elektrischen Kontaktierung 7 und des Fügematerials 10 können die Schichten, welche die Haftvermittlungsschicht 12 und die Diffusionsbarriere 11 bilden, auch entfallen.

Zur Herstellung eines thermoelektrischen Moduls können beispielsweise sandgestrahlte, vorzugsweise beidseitig sandgestrahlte Grundmaterialien, verwendet werden. Natürlich kommen auch andere Verfahren zur Oberflächenaktivierung in Frage wie Beizen, Schleifen, Plasmabehandlung etc. Auf diese werden mittels thermischen Spritzens elektrische Isolierungen 4, 5 aufgebracht. Hierzu kann beispielsweise eine keramische Schicht aufgetragen werden. Bei keramischen Schichten, insbesondere bei dickeren keramischen Schichten, wird zunächst eine Zwischenschicht aufgetragen, um Spannungen während der Beschichtung mit der keramischen Schicht zu verringern. Die Zwischenschicht kann dabei beispielsweise eine Pufferschicht zur Kompensation von unterschiedlichen Wärmeausdehnungskoeffizienten bilden.

Auf der keramischen Schicht erfolgt, beispielsweise wiederum durch thermisches Spritzen, die Abscheidung von elektrischen Kontaktierungen 6, 7. Die elektrischen Kontaktierungen 6, 7 können mit einer weiteren Schicht 11, vorzugsweise auch durch thermisches Spritzen, belegt werden. Diese weitere Schicht 11 dient beispielsweise als Barriere gegen die Interdiffusion von Elementen und/oder als Haftgrund. Auch zwischen den elektrischen Kontaktierungen 6, 7 und den elektrischen Isolierungen 4, 5 können wieder Pufferschichten aufgebracht sein.

Sowohl die elektrischen Isolierungen, welche durch keramische Schichten 4, 5 gebildet sind, als auch die elektrischen Kontaktierungen 6, 7 werden beispielsweise über Masken aufgespritzt. Dieses Vorgehen ist hier nicht näher beschrieben.

Die Fig. 2 zeigt im linken Teil eine Aufsicht auf vier nebeneinander angeordnete elektrische Kontaktierungen 20 mit den jeweils darüber oder darunter liegenden elektrischen Isolierungen 21. Wie bereits in der vorangegangenen Beschreibungseinleitung erläutert, ist es besonders vorteilhaft, wenn die elektrische Isolierung 21 nicht vollflächig über das gesamte Gehäuseelement ausgeführt ist, sondern nur die jeweiligen elektrischen Kontaktierungen 20 soweit überragt, dass eine zuverlässige Vermeidung von elektrischen Kurzschlüssen erreicht wird.

Eine nur lokal vorhandene elektrische Isolierung 21 erleichtert das Ausdehnen und das Stauchen des Trägermaterials, welches in diesem Fall durch eines der Gehäuseelemente gebildet ist. Das Gehäuseelement kann durch die nicht vollflächige elektrische Isolierung 21 einfacher die Dehnungen und Stauchungen kompensieren, welche infolge der thermomechanischen Spannungen auftreten.

Eine elektrische Kontaktierung 20 der Fig. 2 verbindet jeweils zwei benachbart zueinander liegende thermoelektrische Elemente miteinander.

Weiterhin ist in Fig. 2 gezeigt, dass die elektrischen Isolierungen 21 derart zueinander beabstandet sind, dass sie im Falle einer extremen Dehnung oder Stauchung des Gehäuseelementes nicht aneinander stoßen. Die Beabstandung trägt ebenfalls dazu bei, dass die Gehäuseelemente die Dehnungen und Stauchungen, welche infolge der thermomechanischen Spannungen auftreten können, besser kompensieren können. Die elektrischen Isolierungen 21 sind dabei um den Abstand 22 in der Breite zueinander beabstandet und in der Höhe um den Abstand 23 zueinander beabstandet.

Die Fig. 2 zeigt im rechten Teil eine Seitenansicht von jeweils zwei elektrischen Isolierungen 21 und zwei elektrischen Kontaktierungen 20 des linken Teils der Fig. 2. Es ist zu erkennen, dass die elektrischen Isolierungen 21 die jeweiligen elektrischen Kontaktierungen 20 überragen.

Alle in den Fig. 1 und 2 gezeigten Ausführungsbeispiele sind beispielhaft und dienen der Beschreibung des Erfindungsgedankens. Sie sind untereinander kombinierbar und besitzen keinen beschränkenden Charakter.

Im Folgenden wird ein weiteres Ausführungsbeispiel beschrieben: Für die kalte Seite wird ein Gehäuseelement aus einer weichgeglühten Al-Folie der Dicke 0,07 mm verwendet. Die Folienoberfläche wird durch Schleifen aktiviert und eine Al-Si-Pufferschicht und anschließend Al₂O₃ einer Dicke von ca. 0,1 mm über thermisches Spritzen segmentiert aufgebracht, d.h. über eine passende Maske thermisch aufgespritzt. Über eine zweite Maske wird auf die Pufferschicht Al als Material für die Leiterbahnen gespritzt. Das Gehäuseelement der heißen Seite besteht aus einer 0,05 mm dicken 1.4737 Edelstahlfolie, auf die im geschliffenen Zustand NiCrAlY und darauf Al₂O₃ über eine dritte Maske aufgespritzt wird. Mittels einer vierten Maske, deren Öffnungen 0,5 mm kleiner sind als die der dritten Maske, wird NiCrAlY und anschließend W als Leiterbahnmaterial für die heiße Seite aufgespritzt. Die Leiterbahnen der heißen und der kalten Seite werden zuletzt unter Verwendung der zweiten und der vierten Maske mit einer Ag-Haftvermittlungsschicht möglichst dünn belegt. Als thermoelektrisch aktives Material dienen n- und p-dotierte CoSb₃-Klötzchen, die an zwei gegenüberliegenden Seiten mit einer mehrlagigen Metallisierung versehen sind, die auf der Außenseite aus Ag besteht. Die Leiterbahnen werden über Siebdruck mit Ag-Sinterpaste belegt. Anschließend werden die gedruckten Gehäuseelemente und die TE-Klötzchen zu einem TE-Modul kassettiert und unter Anwendung von Druck und Temperatur zu einem festen Modul versintert. Das Modul weist eine hohe thermomechanische Beständigkeit auf.

## Patentansprüche

1. Thermoelektrisches Modul (1) mit einem ersten Gehäuseelement (2, 3) und mit einem zweiten Gehäuseelement (2, 3), wobei zwischen den Gehäuseelementen (2, 3) zumindest zwei thermoelektrische Elemente (8, 9) angeordnet sind, wobei zumindest jeweils zwei thermoelektrische Elemente (8, 9) über erste elektrische Kontaktierungen (6, 7, 20) oder über zweite elektrische Kontaktierungen (6, 7, 20) miteinander elektrisch verbunden sind oder die zumindest jeweils zwei thermoelektrischen Elemente über erste elektrische Kontaktierungen (6, 7, 20) und/oder zweite elektrische Kontaktierungen (6, 7, 20) mit einem Stromkreis elektrisch verbunden sind, wobei die ersten elektrischen Kontaktierungen (6, 7, 20) dem ersten Gehäuseelement (2, 3) zugeordnet sind und die zweiten elektrischen Kontaktierungen (6, 7, 20) dem zweiten Gehäuseelement (2, 3) zugeordnet sind, wobei das erste Gehäuseelement (2, 3) und/oder das zweite Gehäuseelement (2, 3) eine Dicke von weniger als 0,3 mm aufweist, **dadurch gekennzeichnet, dass** der Wärmeausdehnungskoeffizient a des ersten Gehäuseelementes und der ersten elektrischen Kontaktierungen größer ist als der Wärmeausdehnungskoeffizient a des zweiten Gehäuseelementes und der zweiten elektrischen Kontaktierungen.

2. Thermoelektrisches Modul (1) nach Anspruch 1, **dadurch gekennzeichnet, dass** das erste Gehäuseelement (2, 3) und/oder das zweite Gehäuseelement (2, 3) eine Dicke von weniger als 0,2 mm, bevorzugt von weniger als 0,1 mm aufweist.

3. Thermoelektrisches Modul (1) nach einem der vorhergehenden Ansprüche, **dadurch gekennzeichnet, dass** das erste Gehäuseelement (2, 3) aus zumindest einem der Materialien Aluminium, Magnesium, Zink, Kupfer und Mangan gebildet ist oder aus einer Legierung von zumindest einem der Materialien Aluminium, Magnesium, Zink, Kupfer, Mangan und Eisen gebildet ist, wobei das zweite Gehäuseelement (2, 3) aus einem Material mit einem Wärmeausdehnungskoeffizienten a gebildet ist, der kleiner als 20 x 10⁻⁶ 1/K ist, dabei vorzugsweise kleiner als 16 x 10⁻⁶ 1/K ist, dabei vorzugsweise kleiner als 12 x 10⁻⁶ 1/K ist.

4. Thermoelektrisches Modul (1) nach einem der vorhergehenden Ansprüche, **dadurch gekennzeichnet, dass** das zweite Gehäuseelement (2, 3) aus zumindest einem der Materialien Molybdän, Wolfram, Tantal, Niob, Chrom, Nickel, Aluminiumoxid, Aluminiumnitrid, Zirkonoxid , Siliziumcarbid, Siliziumnitrid gebildet ist oder aus einer Legierung aus zumindest einem der Materialien Molybdän, Wolfram, Tantal, Niob, Chrom, Nickel und Eisen, gebildet ist.

5. Thermoelektrisches Modul (1) nach einem der vorhergehenden Ansprüche, **dadurch gekennzeichnet, dass** das Gehäuseelement auf der im Betrieb zu kühlenden kalten Seite aus einem Metall besteht.

6. Thermoelektrisches Modul (1) nach einem der vorhergehenden Ansprüche, **dadurch gekennzeichnet, dass** jeweils zwischen den ersten elektrischen Kontaktierungen (6, 7, 20) und dem ersten Gehäuseelement (2, 3) und/oder zwischen den zweiten elektrischen Kontaktierungen (6, 7, 20) und dem zweiten Gehäuseelement (2, 3) eine elektrische Isolierung (4, 5, 21) angeordnet ist.

7. Thermoelektrisches Modul (1) nach einem der vorhergehenden Ansprüche, **dadurch gekennzeichnet, dass** die elektrische Isolierung (4, 5, 21) die geometrische Form der elektrischen Kontaktierungen aufweist, jedoch zwischen 0,1 und 1,0 mm, bevorzugt zwischen 0,25 und 0,75 mm, über diese hinaussteht.

8. Thermoelektrisches Modul (1) nach einem der vorhergehenden Ansprüche, **dadurch gekennzeichnet, dass** die elektrische Isolierung (4, 5, 21) und/oder die elektrischen Kontaktierungen (6, 7, 20) durch thermisches Spritzen auf die Gehäuseelemente (2, 3) und/oder die thermoelektrischen Elemente (8, 9) aufgebracht ist.

9. Thermoelektrisches Modul (1) nach einem der vorhergehenden Ansprüche, **dadurch gekennzeichnet, dass** für das erste Gehäuseelement (2, 3) und/oder die ersten elektrischen Kontaktierungen (6, 7, 20) ein Material verwendbar ist, dessen Elastizitätsmodul E in einem Bereich von 5 GPa bis 200 GPa, bevorzugt von 15 GPa bis 120 GPa, dabei bevorzugt von 20 GPa bis 100 GPa liegt.

10. Thermoelektrisches Modul (1) nach einem der vorhergehenden Ansprüche, **dadurch gekennzeichnet, dass** für das zweite Gehäuseelement (2, 3) und/oder die zweiten elektrischen Kontaktierungen (6, 7, 20) ein Material verwendbar ist, dessen Elastizitätsmodul E in einem Bereich von 100 GPa bis 500 GPa, bevorzugt von 140 GPa bis 300 GPa, dabei bevorzugt von 160 GPa bis 250 GPA liegt.

11. Thermoelektrisches Modul (1) nach einem der vorhergehenden Ansprüche, **dadurch gekennzeichnet, dass** die ersten elektrischen Kontaktierungen (6, 7, 20) und/oder die zweiten elektrischen Kontaktierungen (6, 7, 20) aus einem mehrlagigen Material gebildet sind.

12. Thermoelektrisches Modul (1) nach einem der vorhergehenden Ansprüche, **dadurch gekennzeichnet, dass** die ersten elektrischen Kontaktierungen (6, 7, 20) und/oder die zweiten elektrischen Kontaktierungen (6, 7, 20) durch Leiterbahnen gebildet sind, wobei diese bevorzugt mehr als 1 mm, dabei bevorzugt mehr als 2 mm, dabei bevorzugt mehr als 3 mm zueinander beabstandet sind.

13. Thermoelektrisches Modul (1) nach einem der vorhergehenden Ansprüche, **dadurch gekennzeichnet, dass** das Fügen der jeweiligen Gehäuseelemente (2, 3) und der jeweiligen elektrischen Kontaktierungen (6, 7, 20) bei einer Temperatur erfolgt, welche in einem Intervall von ± 50° Celsius um eine Mitteltemperatur zwischen der Umgebungstemperatur und der jeweiligen Anwendungstemperatur des thermoelektrischen Moduls (1) liegt.

14. Thermoelektrisches Modul (1) nach einem der vorhergehenden Ansprüche, **dadurch gekennzeichnet, dass** die ersten elektrischen Kontaktierungen und/oder die zweiten elektrischen Kontaktierungen (6, 7, 20) aus einem Material gebildet sind, das einen möglichst niedrigen spezifischen elektrischen Widerstand (σ) von kleiner 0,6 Ωmm²/m aufweist, dabei vorzugsweise kleiner als 0,1 Ωmm²/m, dabei vorzugsweise kleiner als 0,06 Ωmm²/m.

15. Thermoelektrisches Modul (1) nach einem der vorhergehenden Ansprüche **dadurch gekennzeichnet, dass** zwischen einzelnen Schichten (11, 12), Leiterbahnen und/oder thermoelektrischen Bausteinen Pufferschichten, insbesondere aus NiCrAlY, einer Al-Cu-Legierungen oder einer Al-Si-Legierung, aufgebracht sind.

## Claims

1. A thermoelectric module (1) with a first housing element (2, 3) and with a second housing element (2, 3), wherein at least two thermoelectric elements (8, 9) are arranged between the housing elements (2, 3), wherein at least in each case two thermoelectric elements (8, 9) are electrically connected to one another via first electrical contacts (6, 7, 20) or via second electrical contacts (6, 7, 20) or the at least in each case two thermoelectric elements are electrically connected to an electric circuit via first electrical contacts (6, 7, 20) and/or second electrical contacts (6, 7, 20), wherein the first electrical contacts (6, 7, 20) are assigned to the first housing element (2, 3) and the second electrical contacts (6, 7, 20) are assigned to the second housing element (2, 3), wherein the first housing element (2, 3) and/or the second housing element (2, 3) has a thickness of less than 0.3 mm, **characterised in that** the thermal expansion coefficient α of the first housing element and of the first electrical contacts is greater than the thermal expansion coefficient α of the second housing element and of the second electrical contacts.

2. The thermoelectric module (1) according to claim 1, **characterised in that** the first housing element (2, 3) and/or the second housing element (2, 3) has a thickness of less than 0.2 mm, preferably of less than 0.1 mm.

3. The thermoelectric module (1) according to one of the preceding claims, **characterised in that** the first housing element (2, 3) is formed from at least one of the materials of aluminium, magnesium, zinc, copper and manganese, or is formed from an alloy of at least one of the materials of aluminium, magnesium, zinc, copper, manganese and iron, wherein the second housing element (2, 3) is formed from a material with a thermal expansion coefficient α which is smaller than 20 x 10⁻⁶ 1/K, preferably smaller than 16 x 10⁻⁶ 1/K, preferably smaller than 12 x 10⁻⁶ 1/K.

4. The thermoelectric module (1) according to one of the preceding claims, **characterised in that** the second housing element (2, 3) is formed from at least one of the materials of molybdenum, tungsten, tantalum, niobium, chromium, nickel, aluminium oxide, aluminium nitride, zirconia, silicon carbide, silicon nitride, or is formed from an alloy of at least one of the materials of molybdenum, tungsten, tantalum, niobium, chromium, nickel and iron.

5. The thermoelectric module (1) according to one of the preceding claims, **characterised in that** the housing element consists of a metal on the cold side to be cooled during operation.

6. The thermoelectric module (1) according to one of the preceding claims, **characterised in that** in each case between the first electrical contacts (6, 7, 20) and the first housing element (2, 3) and/or between the second electrical contacts (6, 7, 20) and the second housing element (2, 3), an electrical insulation (4, 5, 21) is arranged.

7. The thermoelectric module (1) according to one of the preceding claims, **characterised in that** the electrical insulation (4, 5, 21) has the geometric shape of the electrical contacts, however, protrudes beyond the latter by 0.1 to 1.0 mm, preferably by 0.25 to 0.75 mm.

8. The thermoelectric module (1) according to one of the preceding claims, **characterised in that** the electrical insulation (4, 5, 21) and/or the electrical contacts (6, 7, 20) are applied to the housing elements (2, 3) and/or the thermoelectric elements (8, 9) by thermal spraying.

9. The thermoelectric module (1) according to one of the preceding claims, **characterised in that** for the first housing element (2, 3) and/or the first electrical contacts (6, 7, 20), a material can be used whose modulus of elasticity E is within a range of 5 GPa to 200 GPa, preferably 15 GPa to 120 GPa, preferably 20 GPa to 100 GPa.

10. The thermoelectric module (1) according to one of the preceding claims, **characterised in that** for the second housing element (2, 3) and/or the second electrical contacts (6, 7, 20), a material can be used whose modulus of elasticity E is within a range of 100 GPa to 500 GPa, preferably 140 GPa to 300 GPa, preferably 160 GPa to 250 GPa.

11. The thermoelectric module (1) according to one of the preceding claims, **characterised in that** the first electrical contacts (6, 7, 20) and/or the second electrical contacts (6, 7, 20) are formed from a multilayer material.

12. The thermoelectric module (1) according to one of the preceding claims, **characterised in that** the first electrical contacts (6, 7, 20) and/or the second electrical contacts (6, 7, 20) are formed by conductor tracks, wherein these are preferably spaced apart from one another by more than 1 mm, preferably by more than 2 mm, preferably by more than 3 mm.

13. The thermoelectric module (1) according to one of the preceding claims, **characterised in that** the joining of the respective housing elements (2, 3) and the respective electrical contacts (6, 7, 20) is carried out at a temperature which is in an interval of ±50° Celsius about a central temperature between the ambient temperature and the respective application temperature of the thermoelectric module (1).

14. The thermoelectric module (1) according to one of the preceding claims, **characterised in that** the first electrical contacts and/or the second electrical contacts (6, 7, 20) are formed from a material having a lowest possible specific electrical resistivity (σ) of less than 0.6 Ωmm²/m, preferably less than 0.1 Ωmm²/m, preferably less than 0.06 Ωmm²/m.

15. The thermoelectric module (1) according to one of the preceding claims, **characterised in that** between individual layers (11, 12), conductor tracks and/or thermoelectric components, buffer layers, in particular from NiCrAlY, an Al-Cu alloy or an Al-Si alloy, are applied.

## Revendications

1. Module thermoélectrique (1) comprenant un premier élément de boîtier (2, 3) et comprenant un deuxième élément de boîtier (2, 3), où au moins deux éléments thermoélectriques (8, 9) sont disposés entre les éléments de boîtier (2, 3), où au moins deux éléments thermoélectriques (8, 9) sont à chaque fois reliés électriquement l'un à l'autre par des premiers contacts électriques (6, 7, 20) ou par des deuxièmes contacts électriques (6, 7, 20), ou bien les éléments thermoélectriques au moins au nombre de deux sont à chaque fois reliés électriquement à un circuit électrique, par des premiers contacts électriques (6, 7, 20) et / ou par des deuxièmes contacts électriques (6, 7, 20), où les premiers contacts électriques (6, 7, 20) sont associés au premier élément de boîtier (2, 3), et les deuxièmes contacts électriques (6, 7, 20) sont associés au deuxième élément de boîtier (2, 3), où le premier élément de boîtier (2, 3) et / ou le deuxième élément de boîtier (2, 3) présente une épaisseur de moins de 0,3 mm, **caractérisé en ce que** le coefficient de dilatation thermique α du premier élément de boîtier et des premiers contacts électriques est supérieur au coefficient de dilatation thermique α du deuxième élément de boîtier et des deuxièmes contacts électriques.

2. Module thermoélectrique (1) selon la revendication 1, **caractérisé en ce que** le premier élément de boîtier (2, 3) et / ou le deuxième élément de boîtier (2, 3) présente une épaisseur de moins de 0,2 mm, de préférence de moins de 0,1 mm.

3. Module thermoélectrique (1) selon l'une des revendications précédentes, **caractérisé en ce que** le premier élément de boîtier (2, 3) est formé à partir d'au moins l'un des matériaux parmi l'aluminium, le magnésium, le zinc, le cuivre et le manganèse, ou bien est formé à partir d'un alliage au moins de l'un des matériaux parmi l'aluminium, le magnésium, le zinc, le cuivre, le manganèse et le fer, où le deuxième élément de boîtier (2, 3) est formé à partir d'un matériau ayant un coefficient de dilatation thermique α qui est inférieur à 20 x 10⁻⁶ 1/K, ici de préférence inférieur à 16 x 10⁻⁶ 1/K, ici de préférence inférieur à 12 x 10⁻⁶ 1/K.

4. Module thermoélectrique (1) selon l'une quelconque des revendications précédentes, **caractérisé en ce que** le deuxième élément de boîtier (2, 3) est formé à partir d'au moins l'un des matériaux parmi le molybdène, le tungstène, le tantale, le niobium, le chrome, le nickel, l'oxyde d'aluminium, le nitrure d'aluminium, l'oxyde de zirconium, le carbure de silicium, le nitrure de silicium, ou bien est formé à partir d'un alliage au moins de l'un des matériaux parmi le molybdène, le tungstène, le tantale, le niobium, le chrome, le nickel et le fer.

5. Module thermoélectrique (1) selon l'une quelconque des revendications précédentes, **caractérisé en ce que** l'élément de boîtier, sur le côté froid à refroidir au cours du fonctionnement, se compose d'un métal.

6. Module thermoélectrique (1) selon l'une quelconque des revendications précédentes, **caractérisé en ce qu'**un isolant électrique (4, 5, 21) est disposé à chaque fois entre les premiers contacts électriques (6, 7, 20) et le premier élément de boîtier (2, 3) et / ou entre les deuxièmes contacts électriques (6, 7, 20) et le deuxième élément de boîtier (2, 3).

7. Module thermoélectrique (1) selon l'une quelconque des revendications précédentes, **caractérisé en ce que** l'isolant électrique (4, 5, 21) présente la forme géométrique des contacts électriques, étant cependant en saillie par rapport à ces contacts électriques, avec un dépassement compris entre 0,1 mm et 1,0 mm, de préférence compris entre 0,25 mm et 0,75 mm.

8. Module thermoélectrique (1) selon l'une quelconque des revendications précédentes, **caractérisé en ce que** l'isolant électrique (4, 5, 21) et / ou les contacts électriques (6, 7, 20) sont appliqués, par projection thermique, sur les éléments de boîtier (2, 3) et / ou sur les éléments thermoélectriques (8, 9).

9. Module thermoélectrique (1) selon l'une quelconque des revendications précédentes, **caractérisé en ce que**, pour le premier élément de boîtier (2, 3) et / ou pour les premiers contacts électriques (6, 7, 20), on peut utiliser un matériau dont le module d'élasticité E se situe dans une plage allant de 5 GPa à 200 GPa, de préférence de 15 GPa à 120 GPa, allant ici de préférence de 20 GPa à 100 GPa.

10. Module thermoélectrique (1) selon l'une quelconque des revendications précédentes, **caractérisé en ce que**, pour le deuxième élément de boîtier (2, 3) et / ou pour les deuxièmes contacts électriques (6, 7, 20), on peut utiliser un matériau dont le module d'élasticité E se situe dans une plage allant de 100 GPa à 500 GPa, de préférence de 140 GPa à 300 GPa, allant ici de préférence de 160 GPa à 250 GPa.

11. Module thermoélectrique (1) selon l'une quelconque des revendications précédentes, **caractérisé en ce que** les premiers contacts électriques (6, 7, 20) et / ou les deuxièmes contacts électriques (6, 7, 20) sont formés à partir d'un matériau en plusieurs couches.

12. Module thermoélectrique (1) selon l'une quelconque des revendications précédentes, **caractérisé en ce que** les premiers contacts électriques (6, 7, 20) et / ou les deuxièmes contacts électriques (6, 7, 20) sont formés par des pistes conductrices, où celles-ci sont espacées les unes des autres, de préférence de plus de 1 mm, ici de préférence de plus de 2 mm, ici de préférence de plus de 3 mm.

13. Module thermoélectrique (1) selon l'une quelconque des revendications précédentes, **caractérisé en ce que** la jonction des éléments de boîtier respectifs (2, 3) et des contacts électriques respectifs (6, 7, 20) se produit à une température qui se situe dans un intervalle de variation de ± 50° Celsius par rapport à une température moyenne comprise entre la température ambiante et la température d'utilisation respective du module thermoélectrique (1).

14. Module thermoélectrique (1) selon l'une quelconque des revendications précédentes, **caractérisé en ce que** les premiers contacts électriques et / ou les deuxièmes contacts électriques (6, 7, 20) sont formés à partir d'un matériau qui présente une résistance électrique spécifique (σ) la plus faible possible, inférieure à 0,6 Ωmm²/m, ici de préférence inférieure à 0,1 Ωmm²/m, ici de préférence inférieure à 0,06 Ωmm²/m.

15. Module thermoélectrique (1) selon l'une quelconque des revendications précédentes, **caractérisé en ce que** des pistes conductrices et / ou des couches tampons à composants thermoélectriques, formées en particulier à partir d'un alliage NiCrAlY, de l'un des alliages Al-Cu ou d'un alliage Al-Si, sont appliquées entre différentes couches (11, 12).
